# FASCICULE DE BREVET EUROPEEN

(11) **EP 3 941 009 B1**
(45) Date de publication et mention de la délivrance du brevet: **01.01.2025**
(21) Numéro de dépôt: 21185423.7
(22) Date de dépôt: 13.07.2021
(51) Int. Cl.: H04L 27/02

(54) **DISPOSITIF ET PROCÉDÉ DE RÉCEPTION ET DE DÉMODULATION D'UN SIGNAL RF MODULÉ EN AMPLITUDE**
GERÄT UND VERFAHREN ZUM EMPFANG UND DEMODULATION EINES HF-SIGNALMODULS IN AMPLITUDE
DEVICE AND METHOD FOR RECEIVING AND DEMODULATING AN RF SIGNAL MODULE IN AMPLITUDE

(30) Priorité: 17.07.2020 FR 2007514
(43) Date de publication de la demande: 19.01.2022
(73) Titulaire: Commissariat à l'Energie Atomique et aux Energies Alternatives, 75015 Paris (FR)
(72) Inventeur: JANY, Clément, 38054 GRENOBLE CEDEX 09 (FR); MARTINEAU, Baudouin, 38054 GRENOBLE CEDEX 09 (FR)
(74) Mandataire: Brevalex

(56) Documents cités:
- US-A1- 2007 206 702
- US-A1- 2009 156 155

## Description

### DOMAINE TECHNIQUE

L'invention concerne un dispositif et un procédé de réception et de démodulation d'un signal RF, ou radiofréquence, modulé en amplitude. L'invention est avantageusement utilisée dans un réseau d'émission radiofréquence intégré, par exemple dans le domaine de la communication, du radar, ou de l'imagerie.

### ÉTAT DE LA TECHNIQUE ANTÉRIEURE

Les bandes dites millimétriques (fréquences comprises entre environ 30 et 300 GHz) sont utilisées pour les communications haut débit car elles offrent une bande passante élevée et dans certains cas l'accès à de grandes bandes non-licenciées (par exemple la bande 57-66 GHz). Pour les applications de communications courte portée (plusieurs millimètres à quelques centimètres), la consommation d'énergie est un paramètre très important à considérer, notamment pour les applications nomades (mobiles, tablettes, ...).

La modulation OOK (tout ou rien, ou « On-Off Keying » en anglais) est particulièrement adaptée à ce contexte des communications à haut débit et faible consommation, notamment parce qu'il est possible de démoduler un signal reçu sans avoir recours à une synthèse de fréquence, et ainsi être économe en énergie.

Pour de telles communications, l'utilisation d'une antenne réseau à commande de phase permet d'augmenter le gain de l'antenne équivalente. Lorsque la phase du réseau est programmable, il est même possible de définir la direction dans laquelle pointe le lobe principal du diagramme de rayonnement de l'antenne et ainsi de viser une zone particulière de l'espace.

Le document de A. Poon et al., « Supporting and Enabling Circuits for Antenna Arrays in Wireless Communications », Proceedings of the IEEE, Vol. 100, Issue 7, Juillet 2012, pp. 2207-2218, décrit plusieurs architectures comprenant des antennes réseau à commande de phase. US2009/156155 A1 décrit un dispositif de réception de signal RF au moyen d'une chaîne de réception qui met en oeuvre une démodulation IQ. Toutes ces architectures ne sont toutefois pas applicables aux fréquences dites millimétriques. De plus, ces architectures complexes nécessitent un oscillateur local qui est une source de consommation d'énergie importante.

### EXPOSÉ DE L'INVENTION

L'invention est définie par les revendications indépendantes. Les modes de réalisation sont définis par les revendications dépendantes. Un but de la présente invention est de proposer un dispositif de réception et de démodulation d'un signal RF modulé en amplitude applicables aux bandes millimétriques, permettant, comme les architectures comprenant des antennes réseau à commande de phase de l'art antérieur, d'augmenter le gain de l'antenne équivalente et de définir la direction dans laquelle pointe le lobe principal du diagramme de rayonnement de l'antenne mais dont la consommation électrique soit plus faible et qui soit simple à réaliser que ces architectures, et qui permette également de réaliser une démodulation directe du signal RF modulé en amplitude.

Pour cela, la présente invention propose un dispositif de réception et de démodulation d'un signal RF modulé en amplitude, comprenant au moins :
- une première antenne ;
- un premier amplificateur comprenant une entrée couplée électriquement à une sortie de la première antenne ;
- un module de réception comportant :
   a) une deuxième antenne ;
   b) un deuxième amplificateur comprenant une entrée couplée électriquement à une sortie de la deuxième antenne ;
   c) un déphaseur comprenant une entrée couplée électriquement à une sortie du deuxième amplificateur et configuré pour appliquer un déphasage φ à un signal reçu sur son entrée ;
   d) un mélangeur comprenant une première entrée couplée électriquement à une sortie du déphaseur et une deuxième entrée couplée électriquement à une sortie du premier amplificateur, et configuré pour délivrer sur une sortie un produit de signaux appliqués sur ses première et deuxième entrées,
et dans lequel la valeur du déphasage φ est telle que le dispositif soit configuré pour réaliser une démodulation du signal RF modulé en amplitude reçu par les première et deuxième antennes lorsqu'un front d'onde du signal RF modulé en amplitude forme, avec un axe d'alignement des première et deuxième antennes, un angle α ayant une valeur particulière *a* qui est fonction de celle du déphasage φ et de celle d'une distance entre les première et deuxième antennes.

Dans ce dispositif, le signal reçu par la deuxième antenne est déphasé afin de « compenser » l'avance ou le retard avec lequel ce signal est reçu par rapport à celui reçu par la première antenne, et aligner ainsi temporellement les signaux délivrés par les première et deuxième antennes. Le produit de ces deux signaux réalisé ensuite permet de démoduler directement, en temps réel, le signal RF en translatant l'énergie utile du signal RF dans la bande de base.

En outre, en définissant la valeur du déphasage φ, il est possible de choisir la direction avec laquelle le signal RF modulé en amplitude doit être reçu pour pouvoir être démodulé.

Ce dispositif ne nécessite pas d'oscillateur local, ce qui simplifie sa réalisation et permet d'avoir une consommation électrique plus faible que les architectures utilisant un oscillateur local.

Le dispositif est adapté pour réaliser une réception et une démodulation d'un signal RF modulé en amplitude selon n'importe quel type de modulation d'amplitude, numérique ou analogique (par exemple une modulation d'impulsions en amplitude ou PAM pour « Pulse-Amplitude Modulation » en anglais). Il est toutefois particulièrement bien adapté pour réaliser une réception et une démodulation de signal RF modulé en amplitude selon une modulation d'amplitude numérique telle qu'une modulation OOK ou ASK (modulation par déplacement d'amplitude, ou « Amplitude-Shift Keying » en anglais).

Le dispositif peut comprendre *n* modules de réception, *n* étant un nombre entier supérieur ou égal à 2, comportant chacun :
- une antenne ;
- un amplificateur comprenant une entrée couplée électriquement à une sortie de l'antenne dudit module de réception ;
- un déphaseur comprenant une entrée couplée électriquement à une sortie de l'amplificateur dudit module de réception et configuré pour appliquer le déphasage φ à un signal reçu sur son entrée, la valeur du déphasage φ étant similaire pour tous les déphaseurs des n modules de réception ;
- un mélangeur comprenant une première entrée couplée électriquement à une sortie du déphaseur dudit module de réception et une deuxième entrée couplée électriquement à la sortie d'un amplificateur dont l'entrée est couplée électriquement à une antenne adjacente à celle dudit module de réception, et configuré pour délivrer sur une sortie un produit de signaux appliqués sur ses première et deuxième entrées ;
et dans lequel les antennes des *n* modules de réception et la première antenne sont alignées les unes à côté des autres sur l'axe d'alignement et telles que les distances entre chacune de la première antenne et des antennes des *n* modules de réception et une antenne adjacente soient égales les unes aux autres.

Dans ce dispositif, le module de réception qui comporte la deuxième antenne et le deuxième amplificateur correspond à un des *n* modules de réception.

Le dispositif peut comporter en outre un circuit comprenant plusieurs entrées couplées électriquement aux sorties des mélangeurs des *n* modules de réception et configuré pour réaliser une combinaison linéaire entre des signaux appliqués sur ses entrées. En combinant ainsi les produits de signaux obtenus en sortie des mélangeurs, le rapport signal sur bruit du signal obtenu en sortie du circuit est meilleur que celui obtenu pour chacun des signaux obtenus en sortie des mélangeurs.

De manière avantageuse, la combinaison linéaire peut correspondre à une addition.

Le dispositif peut comporter en outre *n-1* diviseurs de puissance comprenant chacun :
- une entrée couplée électriquement à la sortie de l'amplificateur d'un des n modules de réception ;
- une première sortie couplée électriquement à l'entrée du déphaseur dudit un des n modules de réception ;
- une deuxième sortie couplée électriquement à la deuxième entrée du mélangeur d'un autre des n modules de réception dont l'antenne est adjacente à celle dudit un des n modules de réception.

Le module de réception, ou chacun des *n* modules de réception, peut comporter en outre un filtre passe-bas dont une entrée est couplée électriquement à une sortie du mélangeur dudit module de réception, et lorsque le dispositif comporte le circuit configuré pour réaliser une combinaison linéaire entre les signaux appliqués sur ses entrées, les entrées dudit circuit peuvent être couplées électriquement aux sorties des filtres passe-bas des n modules de réception. De tels filtres passe-bas permettent d'améliorer le spectre du signal démodulé obtenu en supprimant les hautes fréquences présentes dans le signal démodulé et ne conserver ainsi que l'information utile en bande de base.

Une distance entre deux antennes adjacentes dudit dispositif peut être égale à λ/2, avec λ correspondant à la longueur d'onde d'une porteuse du signal RF modulé en amplitude.

Le déphaseur du module de réception ou de chacun des *n* modules de réception peut comporter au moins un modulateur vectoriel, et/ou le mélangeur du module de réception ou de chacun des *n* modules de réception peut comporter au moins une cellule de Gilbert.

L'invention concerne également un procédé de réception d'un signal RF modulé en amplitude, comprenant au moins :
- une réception du signal RF modulé en amplitude par au moins des première et deuxième antennes qui délivrent en sortie respectivement des premier et deuxième signaux de réception, puis
- une amplification des premier et deuxième signaux de réception, puis
- un déphasage φ du deuxième signal de réception amplifié, puis
- une multiplication du premier signal de réception amplifié avec le deuxième signal de réception amplifié et déphasé,
et dans lequel la valeur du déphasage φ est définie préalablement à la réception du signal RF modulé en amplitude en fonction d'une valeur particulière *a* d'un angle α formé entre un front d'onde du signal RF modulé en amplitude et un axe d'alignement des première et deuxième antennes et d'une valeur d'une distance entre les première et deuxième antennes.

Le procédé peut être tel que :
- la réception du signal RF modulé en amplitude est mise en oeuvre par *n+1* antennes qui délivrent *n+1* signaux de réception et qui sont agencées telles que les distances entre chacune de *n+1* antennes et une antenne adjacente soient égales les unes aux autres ;
- l'amplification est mise en oeuvre pour chacun des *n+1* signaux de réception ;
- le déphasage φ est mis en oeuvre pour *n* signaux de réception amplifiés ;
- la multiplication est mise en oeuvre entre chacun des *n* signaux de réception amplifiés et déphasés et un des *n+1* signaux de réception amplifiés et non déphasés issus de deux des *n+1* antennes qui sont adjacentes ;
*n* étant un nombre entier supérieur ou égal à 2.

Le procédé peut comporter en outre la mise en oeuvre d'une combinaison linéaire des signaux correspondant aux résultats des multiplications mises en oeuvre.

Le procédé peut comporter en outre la mise en oeuvre d'un filtrage passe-bas du signal correspondant au résultat de la multiplication mise en oeuvre ou de chacun des signaux correspondant aux résultats des multiplications mises en oeuvre.

Une distance entre deux antennes adjacentes utilisées pour la réception du signal RF modulé en amplitude peut être égale à λ/2, avec λ correspondant à la longueur d'onde d'une porteuse du signal RF modulé en amplitude.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement un dispositif de réception d'un signal RF modulé en amplitude, objet de la présente invention, selon un premier mode de réalisation ;
- la figure 2 représente des exemples de signaux obtenus dans le dispositif de réception d'un signal RF modulé en amplitude, objet de la présente invention, selon le premier mode de réalisation ;
- la figure 3 représente schématiquement un dispositif de réception d'un signal RF modulé en amplitude, objet de la présente invention, selon un deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

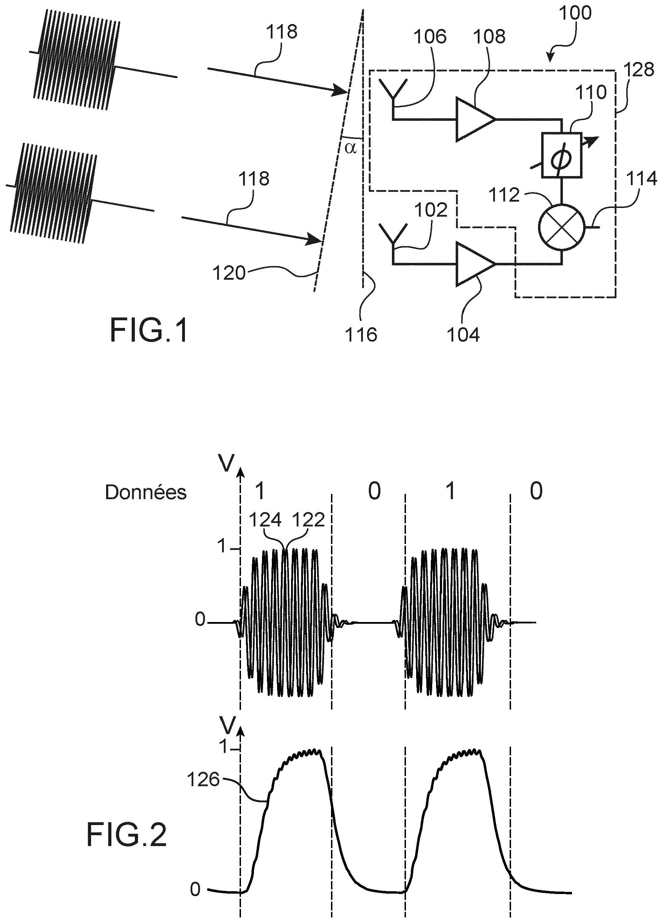

Un dispositif 100 de réception d'un signal RF modulé en amplitude selon un premier mode de réalisation est décrit ci-dessous en lien avec la figure 1 qui représente schématiquement un tel dispositif 100.

Le dispositif 100 comporte une première antenne 102 dont la sortie est couplée électriquement à l'entrée d'un premier amplificateur 104.

Le dispositif 100 comporte également une deuxième antenne 106 dont la sortie est couplée électriquement à l'entrée d'un deuxième amplificateur 108.

Le dispositif 100 comporte également un déphaseur 110 dont l'entrée est couplée électriquement à la sortie du deuxième amplificateur 108. Le déphaseur 110 est configuré pour appliquer un déphasage φ au signal reçu sur son entrée, c'est-à-dire le signal RF reçu par la deuxième antenne 106 et amplifié par le deuxième amplificateur 108. Sur l'exemple de la figure 1, la valeur du déphasage φ appliqué par le déphaseur 110 peut être ajustée. Selon un exemple de réalisation, le déphaseur 110 correspond à un modulateur vectoriel.

Le dispositif 100 comporte en outre un mélangeur 112 comprenant une première entrée couplée électriquement à la sortie du déphaseur 110 et une deuxième entrée couplée électriquement à la sortie du premier amplificateur 104. Le mélangeur 112 est configuré pour délivrer sur une sortie 114 un produit des signaux appliqués sur ses première et deuxième entrées, c'est-à-dire le produit du signal reçu par la première antenne 102 et amplifié par le premier amplificateur 104 et du signal reçu par la deuxième antenne 106, amplifié par le deuxième amplificateur 108 et déphasé par le déphaseur 110. Selon un exemple de réalisation, le mélangeur 112 correspond à une cellule de Gilbert.

Le dispositif 100 est configuré pour recevoir et démoduler un signal RF modulé en amplitude lorsque ce signal arrive avec une orientation particulière par rapport à un axe d'alignement 116 des première et deuxième antennes 102, 106. Sur la figure 1, cette orientation particulière correspond une direction de propagation 118. Le front d'onde du signal RF modulé en amplitude se propageant selon la direction de propagation 118 est désigné, sur la figure 1, par la référence 120 et est perpendiculaire à la direction de propagation 118. Ce front d'onde 120 forme, avec l'axe d'alignement 116, un angle α. L'orientation particulière du signal RF pour laquelle le dispositif 100 réalise la démodulation du signal RF correspond donc également à une valeur particulière de l'angle α, appelée *a*.

La valeur *a* est fonction de la distance entre les première et deuxième antennes 102,106 et de la valeur du déphasage φ appliqué par le déphaseur 110. En effet, dans la configuration du dispositif 100 telle que représentée sur la figure 1, le signal RF à démoduler est reçu par la deuxième antenne 106 en avance par rapport à la première antenne 102. La valeur de cette avance dépend de la distance entre les première et deuxième antennes 102,106 ainsi que de la valeur de l'angle α. Le déphasage φ appliqué par le déphaseur 110 au signal reçu par la deuxième antenne 106 compense cette avance afin que les signaux appliqués sur les deux entrées du mélangeur 112 soient en phase l'un avec l'autre et donc alignés temporellement l'un avec l'autre. Le produit de ces signaux obtenu sur la sortie 114 du mélangeur 112 correspond au signal RF démodulé. La multiplication réalisée par le mélangeur 112 correspond à une translation de l'énergie utile du signal RF dans la bande de base.

En définissant, préalablement à la réception du signal RF modulé en amplitude, la valeur du déphasage φ en fonction de la valeur *a* de l'angle α souhaitée, et en tenant compte de la distance entre les deux antennes 102, 106, le dispositif 100 est alors configuré pour que seuls les signaux RF formant l'angle α = *a* soient correctement démodulés par le dispositif 100, et que d'autres signaux RF dont le front d'onde forme, avec l'axe d'alignement 116, un angle de valeur différente de *a* ne soient pas démodulés par le dispositif 100 du fait que le produit de ces signaux ne reflétera pas l'information transmise par le signal RF modulé en amplitude.

La figure 2 représente des exemples de signaux obtenus dans le dispositif 100 lorsque le front d'onde 120 du signal RF reçu par le dispositif 100 forme, avec l'axe d'alignement 116, un angle α = a. Le signal RF modulé en amplitude reçu par les antennes 102, 106 correspond ici à un signal modulé OOK. Les références 122 et 124 désignent les signaux de réception obtenus en sortie des première et deuxième antennes 102, 106 respectivement. La référence 126 désigne le signal démodulé en bande de base obtenu en sortie du mélangeur 114, et qui correspond à l'information utile transmise par le signal RF modulé en amplitude.

Dans le dispositif 100 précédemment décrit en lien avec la figure 1, la deuxième antenne 106, le deuxième amplificateur 108, le déphaseur 110 et le mélangeur 112 forment ensemble un module de réception 128 coopérant avec la première antenne 102 et le premier amplificateur 104. En variante, le dispositif 100 peut comporter plusieurs modules de réception similaires au module de réception 128.

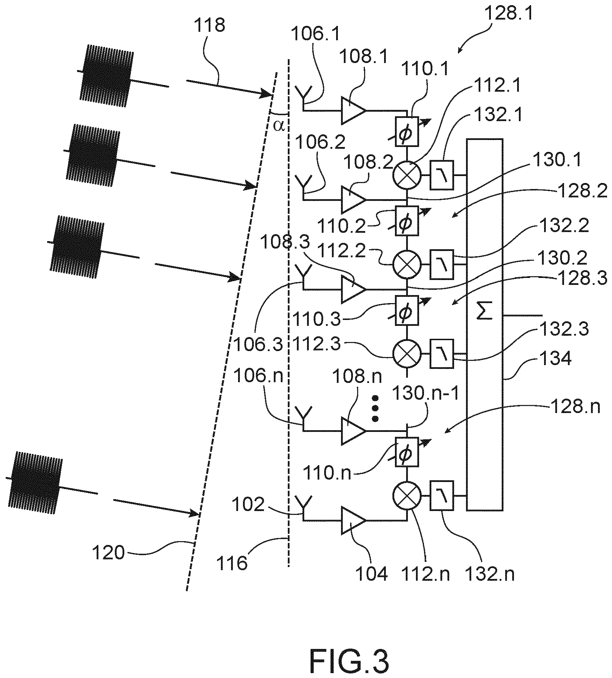

Un dispositif 100 de réception d'un signal RF modulé en amplitude selon un deuxième mode de réalisation est décrit ci-dessous en lien avec la figure 3 qui représente schématiquement un tel dispositif 100.

Contrairement au dispositif 100 selon le premier mode de réalisation précédemment décrit qui ne comporte qu'un seul module de réception 128, le dispositif 100 selon le deuxième mode de réalisation comporte *n* modules de réception 128.1-128.n, n étant un nombre entier supérieur ou égal à 2.

Chacun des *n* modules de réception 128.1-128.n comporte une antenne 106.1-106.n et un amplificateur 108.1-108.n comprenant une entrée couplée électriquement à une sortie de l'antenne 106.1-106.n du module de réception.

Chacun des modules 128.1-128.n comporte également un déphaseur 110.1-110.n comprenant une entrée couplée électriquement à une sortie de l'amplificateur 108.1-108.n du module de réception et configuré pour appliquer un déphasage φ à un signal reçu sur son entrée. La valeur du déphasage φ est similaire pour tous les déphaseurs 110.1-110.n des *n* modules de réception 128.1-128.n.

Chacun des modules 128.1-128.n comporte également un mélangeur 112.1-112.n comprenant une première entrée couplée électriquement à une sortie du déphaseur 110.1-110.n du module de réception et une deuxième entrée couplée électriquement à la sortie d'un des amplificateurs 108.2-108.n et 104 dont l'entrée est couplée à l'une des antennes 106.2-106.n et 102 adjacente à celle du module de réception. Sur l'exemple de la figure 3, la deuxième entrée du mélangeur 112.1 du module de réception 128.1 est couplée électriquement à la sortie de l'amplificateur 108.2 dont l'entrée est couplée électriquement à l'antenne 106.2 qui est adjacente à l'antenne 106.1. De même, la deuxième entrée du mélangeur 112.2 du module de réception 128.2 est couplée électriquement à la sortie de l'amplificateur 108.3 dont l'entrée est couplée électriquement à l'antenne 106.3 qui est adjacente à l'antenne 106.2. Enfin, la deuxième entrée du mélangeur 112.n du module de réception 128.n est couplée électriquement à la sortie de l'amplificateur 104 dont l'entrée est couplée électriquement à l'antenne 102 qui est adjacente à l'antenne 106.n. Chacun des mélangeurs 112.1-112.n est configuré pour délivrer sur sa sortie un signal correspondant au produit de signaux appliqués sur ses première et deuxième entrées.

Dans ce dispositif 100 selon le deuxième mode de réalisation, les antennes 106.1-106.n des *n* modules de réception 128.1-128.n et la première antenne 102 sont alignées les unes à côté des autres sur l'axe d'alignement 116 et sont telles que les distances entre deux antennes adjacentes choisies parmi la première antenne 102 et les antennes 106.1-106.n des n modules de réception 128.1-128.n soient égales les unes aux autres, et ici égale à λ/2, avec λ correspondant à la longueur d'onde d'une porteuse du signal RF modulé en amplitude destiné à être reçu et démodulé par le dispositif 100. Sur l'exemple de la figure 3, la distance entre la première antenne 102 et l'antenne 106.n qui sont adjacentes l'une de l'autre est égale à la distance entre les antennes 106.2 et 106.3 qui sont adjacentes l'une de l'autre, et également égale à la distance entre les antennes 106.2 et 106.1 qui sont adjacentes l'une de l'autre.

Le dispositif 100 représenté sur la figure 3 comporte également *n-1* diviseurs de puissance 130.1-130.n-1 comprenant chacun :
- une entrée couplée électriquement à la sortie de l'amplificateur 108.2-108.n d'un des *n* modules de réception 128.2-128.n ;
- une première sortie couplée électriquement à l'entrée du déphaseur 110.2-110.n dudit un des *n* modules de réception 128.2-128.n ;
- une deuxième sortie couplée électriquement à la deuxième entrée du mélangeur 112.1-112.n-1 d'un autre des *n* modules de réception dont l'antenne 106.1-106.n-1 est adjacente à celle dudit un des *n* modules de réception 128.2-128.n.

Dans ce deuxième mode de réalisation, chacun des modules de réception 128.1-128.n comporte également un filtre passe-bas 132.1-132.n dont une entrée est couplée électriquement à une sortie du mélangeur 112.1-112.n dudit module de réception 128.1-128.n. Un tel filtre passe-bas peut également être couplé à la sortie du mélangeur 114 du dispositif 100 selon le premier mode de réalisation.

Le dispositif 100 comporte également un circuit 134 configuré pour réaliser une combinaison linéaire entre les signaux appliqués sur ses entrées et qui correspondent aux signaux obtenus en sortie des filtres passe-bas 132.1-132.n. Sur l'exemple de la figure 3, la combinaison linéaire réalisée par le circuit 134 correspond à une addition. En variante, d'autres types de combinaisons linéaires sont possibles.

Comme dans le premier mode de réalisation, en définissant, préalablement à la réception du signal RF modulé en amplitude, la valeur du déphasage φ en fonction de la valeur *a* de l'angle α souhaitée, et en tenant compte de la distance entre deux antennes adjacentes choisies parmi les antennes 102 et 106.1-106.n, le dispositif 100 est alors configuré pour que seuls les signaux RF formant l'angle α = *a* soient correctement démodulés par le dispositif 100. Le signal obtenu en sortie de chacun des mélangeurs 112.1-112.n est similaire au signal 126 précédemment décrit en lien avec la figure 2. En réalisant une combinaison linéaire telle qu'une addition sur ces signaux, le rapport signal/bruit obtenu en sortie du circuit 134 est alors amélioré.

## Revendications

1. Dispositif (100) de réception et de démodulation d'un signal RF modulé en amplitude, comprenant au moins :
- une première antenne (102) ;
- un premier amplificateur (104) comprenant une entrée couplée électriquement à une sortie de la première antenne (102) ;
- un module de réception (128, 128.1 - 128.n) comportant :
a) une deuxième antenne (106, 106.1- 106.n) ;
b) un deuxième amplificateur (108, 108.1 - 108.n) comprenant une entrée couplée électriquement à une sortie de la deuxième antenne (106, 106.1 - 106.n) ;
c) un déphaseur (110, 110.1 - 110.n) comprenant une entrée couplée électriquement à une sortie du deuxième amplificateur (108, 108.1 - 108.n) et configuré pour appliquer un déphasage φ à un signal reçu sur son entrée ;
d) un mélangeur (112, 112.1 - 112.n) comprenant une première entrée couplée électriquement à une sortie du déphaseur (110, 110.1 - 110.n) et une deuxième entrée couplée électriquement à une sortie du premier amplificateur (104, 104.1 - 104.n), et configuré pour délivrer sur une sortie un produit de signaux appliqués sur ses première et deuxième entrées,
et dans lequel la valeur du déphasage φ est telle que le dispositif (100) soit configuré pour réaliser une démodulation du signal RF modulé en amplitude reçu par les première et deuxième antennes (102, 106, 106.1 - 106.n) lorsqu'un front d'onde (120) du signal RF modulé en amplitude forme, avec un axe d'alignement (116) des première et deuxième antennes (102, 106, 106.1 - 106.n), un angle α ayant une valeur particulière *a* qui est fonction de celle du déphasage φ et de celle d'une distance entre les première et deuxième antennes (102, 106, 106.1- 106.n).

2. Dispositif (100) selon la revendication 1, comprenant *n* modules de réception (128.1 - 128.n), *n* étant un nombre entier supérieur ou égal à 2, comportant chacun :
- une antenne (106.1 - 106.n) ;
- un amplificateur (108.1 - 108.n) comprenant une entrée couplée électriquement à une sortie de l'antenne (106.1 - 106.n) dudit module de réception (128.1-128.n) ;
- un déphaseur (110.1 - 110.n) comprenant une entrée couplée électriquement à une sortie de l'amplificateur (108.1 - 108.n) dudit module de réception (128.1 - 128.n) et configuré pour appliquer le déphasage φ à un signal reçu sur son entrée, la valeur du déphasage φ étant similaire pour tous les déphaseurs (110.1 - 110.n) des *n* modules de réception (128.1 - 128.n) ;
- un mélangeur (112.1 - 112.n) comprenant une première entrée couplée électriquement à une sortie du déphaseur (110.1 - 110.n) dudit module de réception (128.1 - 128.n) et une deuxième entrée couplée électriquement à la sortie d'un amplificateur (104, 108.2 - 108.n) dont l'entrée est couplée électriquement à une antenne adjacente (102, 106.2 - 106.n) à celle dudit module de réception (128.1 - 128.n), et configuré pour délivrer sur une sortie un produit de signaux appliqués sur ses première et deuxième entrées ;
et dans lequel les antennes (106.1 - 106.n) des *n* modules de réception (128.1 - 128.n) et la première antenne (102) sont alignées les unes à côté des autres sur l'axe d'alignement (116) et telles que les distances entre chacune de la première antenne (102) et des antennes (106.1 - 106.n) des *n* modules de réception (128.1 - 128.n) et une antenne adjacente (102, 106, 106.1 - 106.n) soient égales les unes aux autres.

3. Dispositif (100) selon la revendication 2, comportant en outre un circuit (134) comprenant plusieurs entrées couplées électriquement aux sorties des mélangeurs (112.1 - 112.n) des *n* modules de réception (128.1 - 128.n) et configuré pour réaliser une combinaison linéaire entre des signaux appliqués sur ses entrées.

4. Dispositif (100) selon la revendication 3, dans lequel la combinaison linéaire correspond à une addition.

5. Dispositif (100) selon l'une des revendications 2 à 4, comportant en outre *n-1* diviseurs de puissance (130.1 - 130.n-1) comprenant chacun :
- une entrée couplée électriquement à la sortie de l'amplificateur (108.2 - 108.n) d'un des *n* modules de réception (128.2 - 128.n) ;
- une première sortie couplée électriquement à l'entrée du déphaseur (110.2 - 110.n) dudit un des *n* modules de réception (128.2 - 128.n) ;
- une deuxième sortie couplée électriquement à la deuxième entrée du mélangeur (112.1 - 112.n-1) d'un autre des *n* modules de réception (128.1 - 128.n-1) dont l'antenne (106.1 - 106.n-1) est adjacente à celle dudit un des *n* modules de réception (128.2 - 128.n).

6. Dispositif (100) selon l'une des revendications précédentes, dans lequel le module de réception (128), ou chacun des *n* modules de réception (128.1 - 128.n), comporte en outre un filtre passe-bas (132.1 - 132.n) dont une entrée est couplée électriquement à une sortie du mélangeur (112, 112.1 - 112.n) dudit module de réception (128, 128.1 - 128.n), et dans lequel, lorsque le dispositif (100) comporte le circuit (134) configuré pour réaliser une combinaison linéaire entre les signaux appliqués sur ses entrées, les entrées dudit circuit (134) sont couplées électriquement aux sorties des filtres passe-bas (132.1 - 132.n) des *n* modules de réception (128.1 - 128.n).

7. Dispositif (100) selon l'une des revendications précédentes, dans lequel une distance entre deux antennes adjacentes (102, 106, 106.1 - 106.n) dudit dispositif (100) est égale à λ/2, avec λ correspondant à la longueur d'onde d'une porteuse du signal RF modulé en amplitude.

8. Dispositif (100) selon l'une des revendications précédentes, dans lequel le déphaseur (110, 110.1 - 110.n) du module de réception (128) ou de chacun des *n* modules de réception (128.1 - 128.n) comporte au moins un modulateur vectoriel, et/ou le mélangeur (112, 112.1 - 112.n) du module de réception (128) ou de chacun des *n* modules de réception (128.1 - 128.n) comporte au moins une cellule de Gilbert.

9. Procédé de réception d'un signal RF modulé en amplitude, comprenant au moins :
- une réception du signal RF modulé en amplitude par au moins des première et deuxième antennes (102, 106, 106.1 - 106.n) qui délivrent en sortie respectivement des premier et deuxième signaux de réception, puis
- une amplification des premier et deuxième signaux de réception, puis
- un déphasage φ du deuxième signal de réception amplifié, puis
- une multiplication du premier signal de réception amplifié avec le deuxième signal de réception amplifié et déphasé,
et dans lequel la valeur du déphasage φ est définie préalablement à la réception du signal RF modulé en amplitude en fonction d'une valeur particulière *a* d'un angle α formé entre un front d'onde (120) du signal RF modulé en amplitude et un axe d'alignement (116) des première et deuxième antennes (102, 106, 106.1 - 106.n) et d'une valeur d'une distance entre les première et deuxième antennes (102, 106, 106.1- 106.n).

10. Procédé selon la revendication 9, dans lequel :
- la réception du signal RF modulé en amplitude est mise en oeuvre par *n+1* antennes (102, 106.1 - 106.n) qui délivrent *n+1* signaux de réception et qui sont agencées telles que les distances entre chacune de *n+1* antennes (102, 106.1 - 106.n) et une antenne adjacente (102, 106.1-106.n) soient égales les unes aux autres ;
- l'amplification est mise en oeuvre pour chacun des *n+1* signaux de réception ;
- le déphasage φ est mis en oeuvre pour *n* signaux de réception amplifiés ;
- la multiplication est mise en oeuvre entre chacun des *n* signaux de réception amplifiés et déphasés et un des *n+1* signaux de réception amplifiés et non déphasés issus de deux des *n+1* antennes qui sont adjacentes ;
*n* étant un nombre entier supérieur ou égal à 2.

11. Procédé selon la revendication 10, comportant en outre la mise en oeuvre d'une combinaison linéaire des signaux correspondant aux résultats des multiplications mises en oeuvre.

12. Procédé selon la revendication 11, dans lequel la combinaison linéaire correspond à une addition.

13. Procédé selon l'une des revendications 9 à 12, comportant en outre la mise en oeuvre d'un filtrage passe-bas du signal correspondant au résultat de la multiplication mise en oeuvre ou de chacun des signaux correspondant aux résultats des multiplications mises en oeuvre.

14. Procédé selon l'une des revendications 9 à 13, dans lequel une distance entre deux antennes adjacentes (102, 106, 106.1 - 106.n) utilisées pour la réception du signal RF modulé en amplitude est égale à λ/2, avec λ correspondant à la longueur d'onde d'une porteuse du signal RF modulé en amplitude.

## Patentansprüche

1. Vorrichtung (100) zum Empfangen und Demodulieren eines amplitudenmodulierten HF-Signals, mindestens umfassend:
- eine erste Antenne (102);
- einen ersten Verstärker (104), einen Eingang umfassend, der elektrisch mit einem Ausgang der ersten Antenne (102) gekoppelt ist;
- ein Empfangsmodul (128, 128.1-128.n), enthaltend:
a) eine zweite Antenne (106, 106.1-106.n);
b) einen zweiten Verstärker (108, 108.1-108.n), einen Eingang umfassend, der elektrisch mit einem Ausgang der zweiten Antenne (106, 106.1-106.n) gekoppelt ist;
c) einen Phasenverschieber (110, 110.1-110.n), der einen Eingang umfasst, der elektrisch mit einem Ausgang des zweiten Verstärkers (108, 108.1-108.n) gekoppelt ist, und konfiguriert ist, um eine Phasenverschiebung Φ auf ein Signal anzuwenden, das an seinem Eingang empfangen wird;
d) einen Mischer (112, 112.1-112.n), der einen ersten Eingang umfasst, der elektrisch mit einem Ausgang des Phasenverschiebers (110, 110.1-110.n) gekoppelt ist, und einen zweiten Eingang, der elektrisch mit einem Ausgang des ersten Verstärkers (104, 104.1-104.n) gekoppelt ist, und konfiguriert ist, um an einem Ausgang ein Produkt von Signalen auszugeben, die an seinen ersten und zweiten Eingang angelegt werden,
und wobei der Wert der Phasenverschiebung Φ so ist, dass die Vorrichtung (100) konfiguriert ist, um eine Demodulation des amplitudenmodulierten HF-Signals zu realisieren, das von der ersten und zweiten Antenne (102, 106, 106.1-106.n) empfangen wird, wenn eine Wellenfront (120) des amplitudenmodulierten HF-Signals mit einer Ausrichtungsachse (116) der ersten und zweiten Antenne (102, 106, 106.1-106.n) einen Winkel α bildet, der einen bestimmten Wert *a* aufweist, der von dem der Phasenverschiebung Φ und dem eines Abstands zwischen der ersten und der zweiten Antenne (102, 106, 106.1-106.n) abhängt.

2. Vorrichtung (100) nach Anspruch 1, *n* Empfangsmodule (128.1-128.n) umfassend, wobei n eine ganze Zahl größer oder gleich 2 ist, und jeweils enthaltend:
- eine Antenne (106.1-106.n);
- einen Verstärker (108.1-108.n), einen Eingang umfassend, der elektrisch mit einem Ausgang der Antenne (106.1-106.n) des Empfangsmoduls (128.1-128.n) gekoppelt ist;
- einen Phasenverschieber (110.1-110.n), der einen Eingang umfasst, der elektrisch mit einem Ausgang des Verstärkers (108.1-108.n) des Empfangsmoduls (128.1-128.n) gekoppelt ist, und konfiguriert ist, um die Phasenverschiebung Φ auf ein Signal anzuwenden, das an seinem Eingang empfangen wird, wobei der Wert der Phasenverschiebung für alle Phasenverschieber (110.1-110.n) der *n* Empfangsmodule (128.1-128.n) ähnlich ist;
- einen Mischer (112.1-112.n), der einen ersten Eingang umfasst, der elektrisch mit einem Ausgang des Phasenverschiebers (110.1-110.n) des Empfangsmoduls (128.1-128.n) gekoppelt ist, und einen zweiten Eingang, der elektrisch mit dem Ausgang eines Verstärkers (104, 108.2-108.n) gekoppelt ist, dessen Eingang elektrisch mit einer benachbarten Antenne (102, 106.2-106.n) gekoppelt ist, an die des Empfangsmoduls (128.1-128.n), und konfiguriert ist, um an einem Ausgang ein Produkt von Signalen auszugeben, die an seinen ersten und zweiten Eingang angelegt werden;
und wobei die Antennen (106.1-106.n) der *n* Empfangsmodule (128.1-128.n) und die erste Antenne (102) nebeneinander auf der Ausrichtungsachse (116) ausgerichtet sind, und derart, dass die Abstände zwischen jeder der ersten Antenne (102) und den Antennen (106.1-106.n) der *n* Empfangsmodule (128.1-128.n) und einer benachbarten Antenne (102, 106, 106.1-106.n) einander gleich sind.

3. Vorrichtung (100) nach Anspruch 2, die ferner eine Schaltung (134) enthält, die mehrere Eingänge umfasst, die elektrisch mit den Ausgängen der Mischer (112.1-112.n) der *n* Empfangsmodule (128.1-128.n) gekoppelt sind, und konfiguriert ist, um eine Linearkombination zwischen den Signalen zu realisieren, die an ihren Eingängen angelegt werden.

4. Vorrichtung (100) nach Anspruch 3, wobei die Linearkombination einer Addition entspricht.

5. Vorrichtung (100) nach einem der Ansprüche 2 bis 4, ferner *n-1* Leistungsteiler (130.1-130.n-1) enthaltend, die jeweils umfassen:
- einen Eingang, der elektrisch mit dem Ausgang des Verstärkers (108.2-108.n) eines der *n* Empfangsmodule (128.2-128.n) gekoppelt ist;
- einen ersten Ausgang, der elektrisch mit dem Eingang des Phasenverschiebers (110.2-110.n) eines der *n* Empfangsmodule (128.2-128.n) gekoppelt ist;
- einen zweiten Ausgang, der elektrisch mit dem zweiten Eingang des Mischers (112.1-112.n-1) eines anderen der *n* Empfangsmodule (128.1-128.n-1) gekoppelt ist, dessen Antenne (106.1-106.n-1) zu jener des einen der *n* Empfangsmodule (128.2-128.n) benachbart ist.

6. Vorrichtung (100) nach einem der vorhergehenden Ansprüche, wobei das Empfangsmodul (128) oder jedes der *n* Empfangsmodule (128.1-128.n) ferner ein Tiefpassfilter (132.1-132.n) enthält, dessen einer Eingang elektrisch mit einem Ausgang des Mischers (112, 112.1-112.n) des Empfangsmoduls (128, 128.1-128.n) gekoppelt ist, und wobei, wenn die Vorrichtung (100) die Schaltung (134) enthält, die konfiguriert ist, um eine Linearkombination zwischen den Signalen zu realisieren, die an ihren Eingängen angelegt werden, die Eingänge der Schaltung (134) elektrisch mit den Ausgängen der Tiefpassfilter (132.1-132.n) der *n* Empfangsmodule (128.1-128.n) gekoppelt sind.

7. Vorrichtung (100) nach einem der vorhergehenden Ansprüche, wobei ein Abstand zwischen zwei benachbarten Antennen (102, 106, 106.1-106.n) der Vorrichtung (100) gleich λ/2 ist, wobei λ der Wellenlänge eines Trägers des amplitudenmodulierten HF-Signals entspricht.

8. Vorrichtung (100) nach einem der vorhergehenden Ansprüche, wobei der Phasenverschieber (110, 110.1-110.n) des Empfangsmoduls (128) oder jedes der *n* Empfangsmodule (128.1-128.n) mindestens einen Vektormodulator enthält und/oder den Mischer (112, 112.1-112.n) des Empfangsmoduls (128), oder jedes der n Empfangsmodule (128.1-128.n) mindestens eine Gilbert-Zelle enthält.

9. Verfahren zum Empfangen eines amplitudenmodulierten HF-Signals, mindestens umfassend:
- einen Empfang des amplitudenmodulierten HF-Signals durch mindestens eine erste und zweite Antenne (102, 106, 106.1-106.n), die am Ausgang erste beziehungsweise zweite Empfangssignale ausgeben, dann
- eine Verstärkung des ersten und zweiten Empfangssignals, dann
- eine Phasenverschiebung Φ des zweiten verstärkten Empfangssignals, dann
- eine Multiplikation des ersten verstärkten Empfangssignals mit dem zweiten verstärkten und phasenverschobenen Empfangssignal,
und wobei der Wert der Phasenverschiebung Φ vor dem Empfang des amplitudenmodulierten HF-Signals definiert ist, in Abhängigkeit von einem bestimmten Wert *a* eines Winkels α, der zwischen einer Wellenfront (120) des amplitudenmodulierten HF-Signals und einer Ausrichtungsachse (116) der ersten und zweiten Antenne (102, 106, 106.1-106.n) und einem Wert eines Abstands zwischen der ersten und der zweiten Antenne (102, 106, 106.1-106.n) gebildet wird.

10. Verfahren nach Anspruch 9, wobei:
- der Empfang des amplitudenmodulierten HF-Signals durch *n+1* Antennen (102, 106.1-106.n) implementiert wird, die *n+1* Empfangssignale ausgeben und so angeordnet sind, dass die Abstände zwischen jeder der *n+1* Antennen (102, 106.1-106.n) und einer benachbarten Antenne (102, 106.1-106.n) einander gleich sind;
- die Verstärkung für jedes der *n+1* Empfangssignale implementiert wird;
- die Phasenverschiebung Φ für *n* verstärkte Empfangssignale implementiert wird;
- die Multiplikation implementiert wird zwischen jedem der n verstärkten und phasenverschobenen Empfangssignale und einem der *n+1* verstärkten und nicht phasenverschobenen Empfangssignale, die von zwei der *n*+*1* Antennen hervorgegangen sind, die benachbart sind;
wobei n eine ganze Zahl größer oder gleich 2 ist.

11. Verfahren nach Anspruch 10, ferner die Implementierung einer Linearkombination der Signale enthaltend, die den Ergebnissen der implementierten Multiplikationen entsprechen.

12. Verfahren nach Anspruch 11, wobei die Linearkombination einer Addition entspricht.

13. Verfahren nach einem der Ansprüche 9 bis 12, ferner die Implementierung einer Tiefpassfilterung des Signals enthaltend, das dem Ergebnis der implementierten Multiplikation entspricht, oder jedem der Signale, die den Ergebnissen der implementierten Multiplikationen entsprechen.

14. Verfahren nach einem der Ansprüche 9 bis 13, wobei ein Abstand zwischen zwei benachbarten Antennen (102, 106, 106.1-106.n), die für den Empfang des amplitudenmodulierten HF-Signals verwendet werden, gleich λ/2 ist, wobei λ der Wellenlänge eines Trägers des amplitudenmodulierten HF-Signals entspricht.

## Claims

1. A device (100) for receiving and demodulating an amplitude-modulated RF signal, comprising at least:
- a first antenna (102);
- a first amplifier (104) comprising an input electrically coupled to an output of the first antenna (102);
- a receiving module (128, 128.1-128.n) including:
a) a second antenna (106, 106.1 - 106.n);
b) a second amplifier (108, 108.1 - 108.n) comprising an input electrically coupled to an output of the second antenna(106, 106.1 - 106.n);
c) a phase-shifter (110, 110.1 - 110.n) comprising an input electrically coupled to an output of the second amplifier (108, 108.1 - 108.n) and configured to apply a phase-shift Φ to a signal received on its input;
d) a mixer (112, 112.1 - 112.n) comprising a first input electrically coupled to an output of the phase-shifter (110, 110.1 - 110.n) and a second input electrically coupled to an output of the first amplifier (104, 104.1 - 104.n), and configured to output a product of signals applied on its first and second inputs,
and wherein the value of the phase-shift Φ is such that the device (100) is configured to perform a demodulation of the amplitude-modulated RF signal received by the first and second antennas (102, 106, 106.1 - 106.n) when a wavefront (120) of the amplitude-modulated RF signal forms, with an axis of alignment (116) of the first and second antennas (102, 106, 106.1 - 106.n), an angle α having a particular value *a* which depends on that of the phase-shift Φ and on that of a distance between the first and second antennas (102, 106, 106.1 - 106.n).

2. The device (100) according to claim 1, comprising *n* receiving modules (128.1 - 128.n), *n* being an integer greater than or equal to 2, each including:
- an antenna (106.1-106.n);
- an amplifier (108.1-108.n) comprising an input electrically coupled to an output of the antenna (106.1 - 106.n) of said receiving module (128.1 - 128.n);
- a phase-shifter (110.1-110.n) comprising an input electrically coupled to an output of the amplifier (108.1 - 108.n) of said receiving module (128.1 - 128.n) and configured to apply the phase-shift Φ to a signal received on its input, the value of the phase-shift Φ being similar for all phase-shifters (110.1 - 110.n) of the *n* receiving modules (128.1-128.n);
- a mixer (112.1 - 112.n) comprising a first input electrically coupled to an output of the phase-shifter (110.1 - 110.n) of said receiving module (128.1 - 128.n) and a second input electrically coupled to the output of an amplifier (104, 108.2 - 108.n) whose input is electrically coupled to an antenna adjacent (102, 106, 106.1 - 106.n) to that of said receiving module (128.1 - 128.n), and configured to output a product of signals applied on its first and second inputs;
and wherein the antennas (106.1 - 106.n) of the *n* receiving modules (128.1 - 128.n) and the first antenna (102) are aligned next to one another on the axis of alignment (116) and such that the distances between each of the first antenna (102) and of the antennas (106.1- 106.n) of the *n* receiving modules (128.1 - 128.n) and an adjacent antenna (102, 106, 106.1- 106.n) are equal to one another.

3. The device (100) according to claim 2, further including a circuit (134) comprising several inputs electrically coupled to the outputs of the mixers (112.1 - 112.n) of the *n* receiving modules (128.1 - 128.n) and configured to perform a linear combination between signals applied on its inputs.

4. The device (100) according to claim 3, wherein the linear combination corresponds to an addition.

5. The device (100) according to any of the claims 2 to 4, further including *n-1* power dividers (130.1 - 130.n-1) each comprising:
- an input electrically coupled to the output of the amplifier (108.2 - 108.n) of one of the *n* receiving modules (128.2 - 128.n);
- a first output electrically coupled to the input of the phase-shifter (110.2 - 110.n) of said one of the *n* receiving modules (128.2 - 128.n);
- a second output electrically coupled to the second input of the mixer (112.1 - 112.n-1) of another one of the *n* receiving modules (128.1 - 128.n-1) whose antenna (106.1 - 106.n-1) is adjacent to that of said one of *n* receiving modules (128.2 - 128.n).

6. The device (100) according to any of the previous claims, wherein the receiving module (128), or wherein each of the *n* receiving modules (128.1 - 128.n), further includes a low-pass filter (132.1 - 132.n) whose input is electrically coupled to an output of the mixer (112, 112.1 - 112.n) of the receiving module (128, 128.1 - 128.n), and wherein, when the device (10) includes the circuit (134) configured to perform a linear combination between signals applied on its inputs, the inputs of the circuit (134) are electrically coupled to the outputs of the low-pass filters (132.1 - 132.n) of the *n* receiving modules (128.1-128.n).

7. The device (100) according to any of the previous claims, wherein a distance between two adjacent antennas (102, 106, 106.1 - 106.n) of said device (100) is equal to λ/2, with λ corresponding to the wavelength of a carrier of the amplitude-modulated RF signal.

8. The device (100) according to any of the previous claims, wherein the phase-shifter (110, 110.1 - 110.n) of the receiving module (128) or of each of the *n* receiving modules (128.1-128.n) includes at least one vector modulator, and/or the mixer (112, 112.1 - 112.n) of the receiving module (128) or of each of the *n* receiving modules (128.1 - 128.n) includes at least one Gilbert cell.

9. A method for receiving an amplitude-modulated RF signal, comprising at least:
- a reception of the amplitude-modulated RF signal by at least first and second antennas (102, 106, 106.1 - 106.n) which output respectively the first and second reception signals, then
- an amplification of the first and second reception signals, then
- a phase-shifting Φ of the amplified second reception signal, then
- a multiplication of the amplified first reception signal with the amplified and phase-shifted second reception signal,
and wherein the value of the phase-shift Φ is defined prior to the reception of the amplitude-modulated RF signal as a function of a particular value *a* of an angle α formed between a wavefront (120) of the amplitude-modulated RF signal and an axis of alignment (116) of the first and second antennas (102, 106, 106.1 - 106.n) and of a value of a distance between the first and second antennas (102, 106, 106.1 - 106.n).

10. The method according to claim 9, wherein:
- the reception of the amplitude-modulated RF signal is implemented by *n+1* antennas (102, 106.1 - 106.n) which output *n+1* reception signals and which are arranged such that the distance between each of the n+1 antennas (102, 106.1 - 106.n) and an adjacent antenna (102, 106.1 - 106.n) are equal to one another;
- the amplification is implemented for each of the *n+1* reception signals;
- the phase-shifting Φ is implemented for *n* amplified reception signals;
- the multiplication is implemented between each of the *n* amplified and phase-shifted reception signals and one of the *n+1* amplified and non-phase-shifted reception signals originating from two of the *n+1* antennas that are adjacent;
*n* being an integer greater than or equal 2.

11. The method according to claim 10, further including the implementation of a linear combination of the signals corresponding to the results of the implemented multiplications.

12. The method according to claim 11, wherein the linear combination corresponds to an addition.

13. The method according to any of the claims 9 to 12, further including the implementation of a low-pass filtering of the signal corresponding to the result of the implemented multiplication or of each of the signals corresponding to the results of the implemented multiplications.

14. The method according to any of the claims 9 to 13, further including a distance between two adjacent antennas (102, 106, 106.1-106.n) used for the reception of the amplitude-modulated RF signal is equal to λ/2, with λ corresponding to the wavelength of a carrier of the amplitude-modulated RF signal.
